# EUROPÄISCHE PATENTANMELDUNG

(11) **EP 1 895 608 A2**
(43) Veröffentlichungstag der Anmeldung: **05.03.2008**
(21) Anmeldenummer: 07007413.3
(22) Anmeldetag: 11.04.2007
(51) Int. Cl.: H01L 51/52, H01L 51/56

(54) **Organisches lichtemittierendes Bauteil und Verfahren zum Herstellen**

(30) Priorität: 04.09.2006 EP 06018493
(71) Anmelder: Novaled AG, 01307 Dresden (DE); Degussa AG, 45764 Marl (DE)
(72) Erfinder: Hofmann, Michael, 01187 Dresden (DE); Adam, Dieter, 59494 Soest (DE); Birnstock, Jan, 01187 Dresden (DE); Inhester, Martina, 46244 Bottrop (DE); Lüthge, Thomas, 44139 Dortmund (DE)
(74) Vertreter: Bittner, Thomas L.

(57) **Zusammenfassung**

Die Erfindung betrifft ein organisches lichtemittierendes Bauteil, insbesondere organische Leuchtdiode, bei dem eine Anordnung mit einer Grundelektrode und einer Deckelektrode sowie einem organischen Schichtbereich gebildet ist, welcher zwischen der Grundelektrode und der Deckelektrode und in elektrischem Kontakt mit der Grundelektrode und der Deckelektrode angeordnet ist und welcher mindestens eine Löchertransportschicht, mindestens eine Elektronentransportschicht und einen lichtemittierenden Bereich umfasst, wobei die Grundelektrode mittels nasschemischen Aufbringen aus einer Dispersion als eine strukturierte, bindemittelfreie und optisch transparente Grundelektrodenschicht aus einem Grundelektrodenmaterial gebildet ist, nämlich einem optisch transparenten, elektrisch leitfähigen Oxid, die Grundelektrodenschicht einen Flächenwiderstand von weniger als etwa 500 Ω/Quadrat aufweist, die Grundelektrodenschicht einen optischen Brechungsindex von weniger als 1,8 aufweist, und in einer Strom-Spannungscharakteristik der Anordnung bei einer an die Anordnung angelegten Spannung von etwa -3V ein Sperrstrom kleiner als etwa 10⁻² mA/cm² ist.

## Beschreibung

Die Erfindung bezieht sich auf ein organischen lichtemittierendes Bauteil und ein Verfahren zum Herstellen.

### Hintergrund der Erfindung

Organische lichtemittierende Bauteile wie organische lichtemittierenden Dioden (OLEDs) werden in verschiedensten Anwendungen als Bauteile genutzt, die beim Anlegen einer elektrischen Spannung Licht emittieren. In bestimmten Anwendungen besteht hierbei die Anforderung, ein effizientes, langlebiges, organisches lichtemittierende Bauteil auf einen einfach zu strukturierenden, leitfähigen, transparenten und möglichst Licht streuenden Grundkontakt aufzubringen, welcher eine Grundelektrode des Bauteils bildet.

Ein wichtiger Aspekt ist die einfache und Material sparende Einbindung der Herstellung einer solchen Grundelektrode in einen großtecknischen Fertigungsprozess. Solche Herstellungsprozesse sollen neben der Gewährleistung von bevorzugten physikalischen Eigenschaften des Grundkontaktes üblicherweise weiterhin die folgenden Forderungen erfüllen: optimale Materialausbeute, möglichst wenige Prozessschritte, Variabilität im Layout und Design der Bauteilstrukturen, Variabilität der Substratgröße und eine einfache Skalierbarkeit für großflächige Applikationen.

Bei bekannten organischen lichtemittierenden Bauteilen wird als Grundelektrodenmaterial für die Grundelektrode üblicherweise Indium-Zinn-Oxid (ITO) verwendet. Hierbei wird ITO großflächig auf ein Substrat, beispielsweise Glas, im Vakuum abgeschieden, zum Beispiel mittels der Sputtertechnologie. Danach wird mittels Belichten eines aufgetragenen, lichtempfindlichen Lacks und dessen Strukturierung unter Verwendung von Masken und nach anschließendem Wegätzen des nicht benötigten ITOs die gewünschte Grundelektrodenstruktur erzeugt. Ein wesentlicher Nachteil dieser Standard-Lithographieschritte besteht darin, dass ein Teil des großflächig im Vakuum aufgetragenen Grundeiektrodenmaterials beim Ätzen nachträglich wieder entfernt wird, sodass es als Grundelektrodenmatenal nicht mehr nutzbar ist. Es wird also Material verschwendet. Ein weiterer Nachteil ergibt sich aus der komplexen Strukturierungsmethode. Jeder einzelne Schritt benötigt teuere technische Geräte und verursacht zusätzliche Fertigungskosten.

Alternativ kann das Abscheiden von gewünschten ITO-Leitbahnen mittels Schattenmasken erfolgen. Hierbei tritt jedoch aufgrund von Streueffekten ein sogenanntes Untersputtem auf, was zu unscharfen Rändern der gewünschten Grundelektrodenstruktur und dadurch zu ungenau definierten Strukturkanten führt. Auch hier wird das wertvolle Grundelektmdenmaterial in nur ungenügender Art und Weise ausgenutzt, da der überwiegende Teil auf der Schattenmaske oder an anderen Flächen innerhalb der Vakuumkammer abgeschieden wird.

Falls eine Änderung des Layouts der Grundelektrodenstruktur erforderlich ist, müssen bei den vorangehend beschriebenen Verfahren neue Masken angefertigt werden, was bedeutet, dass die Strukturierung der Grundelektrode stets an das Maskendesign gebunden ist. Hiermit einher geht auch eine Einschränkung hinsichtlich der Variabilität der nutzbaren Substratgröße.

Weitere bekannte Verfahren zum Abscheiden von leitfähigen Oxiden wie ITO, die zum Ausbilden von optisch transparenten Grundelektroden in Form optisch transparenter Grundelektrodenschicht genutzt werden können, sind: PVD (*"Physical Vapour Deposition"*), CVD (*"Chemical Vapour Deposition"*), Verdampfung, Spraypyrolyse, gepulste Laserablation und Ionenstrahlabscheidung. Darüber hinaus wurden Verfahren vorgeschlagen, die auf einer nasschemischen Prozessierung basieren, beispielsweise die Sol-Gel-Technologie (vgl. Aergerter et al., Journal of Sol-Gel Science and Technology 27, Seite 81, 2003). Hierbei wird vor allem mittels Aufschleundern (*"spin-coating"*) einer flüssigen Zusammensetzung auf ein Substrat eine unstrukturierte Schicht erzeugt, die insbesondere als Infrarot-zeflektierende Oberfläche gestaltet sein kann. Des weiteren sind durch Prägung im Submikrometerbereich abgeformte Oberflächen aus leitfähigen Oxiden realisiert worden.

Bei den bekannten Technologien zum Herstellen einer Grundelektrode aus ITO für ein organisches lichtemittierendes Bauteil können häufig die Anforderungen und die Bauteilfunktion beeinflussenden Parameter nur ungenügend erfüllt werden, was im Folgenden näher erläutert wird. Hierzu werden nachfolgend zunächst einige Begrifflichkeiten näher definiert.

Rauhigkeit bezeichnet im Sinne der vorliegenden Anmeldung den quadratischen Mittenrauhwert (RMS - *"Root means square"*), der die mittlere quadratische Höhenabweichung vom durchschnittlichen Höhenniveau in Nanometern (nm) angibt. Die Abtastung der Höhenstruktur erfolgt dabei zum Beispiel mit dem Rasterkraftmikroskop auf einer Messfläche von 10 µm mal 10 µm.

Flächenwiderstand bezeichnet im Sinne der vorliegenden Anmeldung den ohmschen Widerstand, der an einer Schicht mit einer gleichmäßigen Schichtdicke gemessen wird, wenn ein quadratischer Bereich beliebiger Größe an zwei gegenüberliegenden Kanten kontaktiert und der Strom in Abhängigkeit von der (Gleich-) Spannung erfasst wird. Der Flächenwiderstand wird in Ohm (Q) gemessen und in Ω/Quadrat angegeben. Die Bestimmung des Flächenwiderstandes kann auch nach anderen Verfahren erfolgen, zum Beispiel mittels Vierpunktmessung.

Transmissionsvermögen bezeichnet im Sinne der vorliegenden Anmeldung das Durchlässigkeitsvermögen eines Körpers für Licht bei einer bestimmten Wellenlänge. Der sichtbare Wellenlängenbereich ist üblicherweise ein Wellenlängenbereich von 380 nm bis 750 nm. Das Transmissionsvermögen eines beschichteten Glases kann mittels Angabe von Prozentwerten mit dem Transmissionsvermögen desselben unbeschichteten Glases verglichen werden.

Porosität bezeichnet im Sinne der vorliegenden Anmeldung die Eigenschaft eines Materials mit Poren versehen und durchlässig zu sein. Sie wird zahlenmäßig in Prozent angegeben, was den Anteil des Porenvolumens am Gesamtvolumen des betrachteten Materials definiert.

Die elektrische Leitfähigkeit der Grundelektrode skaliert im allgemeinen mit ihrer Schichtdicke. Mit zunehmender Schichtdicke nimmt allerdings die Absorption des Lichtes zu, welches in dem organischen Bereich des lichtemittierenden Bauteiles erzeugt wird, und das Transmissionsvermögen nimmt ab. Kommerziell verfügbare, im Vakuum abgeschiedene ITO-Leiterbahnen wurden unter Berücksichtigung dieser beiden Aspekte für OLED-Anwendungen optimiert. Bei sehr guter Qualität einer TTO-Schicht mit einer Dicke von 100 nm können Flächenwiderstände von 20 bis 50 Ohm/Quadrat erzielt werden. Das Transmissionsvermögen einer solchen Grundelektrode beträgt üblicherweise 90 % bis 95 % im sichtbaren Spektralbereich. Derartige Grundelektroden werden üblicherweise bei erhöhten Temperaturen (>200 °C) mittels Magnetron-Sputtertechnik abgeschieden.

Dem Stand der Technik entsprechende mittels Sputterverfahren hergestellte, optisch transparente Grundelektroden weisen sehr glatte Oberflächen von üblicherweise kleiner 1 nm RMS auf. Dazu geben Datenblätter von Herstellern, wie zum Beispiel das ITO-Datenblatt von Thin Film Devices Inc., Auskunft. Für Anwendungen optisch transparenter Elektroden im Displaybereich (LCD, OLED, FED, Plasma) wird dort eine Oberflächenrauhigkeit von kleiner 1 nm einer 150 nm dicken ITO-Schicht angegeben. So wird beispielsweise das Material ITO auch von der Firma Applied Films mit einem Flächenwiderstand von 13 Ohm/Quadrat und einer gemessenen RMS-Rauhigkeit von 0,8 nm genutzt (siehe Langmuir, 18,2002,450-457).

Trotz ihrer geringen Rauhigkeit besitzen mittels Sputterverfahren hergestellte, transparente Grundelektroden oft lokale Höhenunterschiede *("spikes")* von mehreren Nanometern (>10 nm), deren Anzahl vor allem mit zunehmender Schichtdicke steigt. Die Höhe der lokalen Höhenunterschiede liegt in manchen Fällen in der Größenordnung der Dicke der organischen Schichten, aus denen die OLED aufgebaut ist. In solchen Fällen steigt die Wahrscheinlichkeit von Kurzschlüssen, lokalen Stromdichtespitzen und erhöhten Leckströmen, was üblicherweise zu einer Verminderung der Effizienz und der Lebensdauer des organischen lichtemittierenden Bauteils führt. Dieser Effekt kann zwar mittels einer mechanischen Nachbehandlung der abgeschiedenen ITO-Grundelektrode vermindert werden, indem ein zusätzlicher Polierschritt vorgesehen ist. Dies ist jedoch sehr zeit- und kostenaufwendig.

Das Problem der Oberflächeneigenschaften wird auch in der Literatur diskutiert (Tak et al., Thin Solid Films, 411, 2002, 12-16): Um langlebige OLEDs herstellen zu können, benötigt man sehr glatte ITO-Oberflächen. Die Oberflächenrauhigkeit korreliert mit der Stabilität der OLEDs. Es wird auch diskutiert (siehe J Vac Sc Tech A, 21(4), 2003), dass die Oberflächenrauhigkeit des ITOs einen kritische Faktor insbesondere für OLED Anwendungen darstellt. Der von der Industrie geforderte RMS-Wert beträgt <1 nm. Dem entsprechend seien möglichst atomar glatte Oberflächen zu erzeugen, um Pfade für Leckströme zu eliminieren. In diesem Zusammenhang sind Elektroden mit sehr glatten Oberflächen basierend auf nasschemischem partikulären ITO realisiert worden, deren Schichtebenheit als ein besonderer Vorteil ausgewiesen wird. Die verwendete ITO-Schicht gehört damit zum Stand der Technik

Nach dem Stand der Technik kann eine Nachbehandlung von ITO-Grundkontakten vorgesehen sein. Für eine effiziente Lichterzeugung mittels des organischen lichtemittierenden Bauteils ist es insbesondere notwendig, dass die positiven und negativen Ladungsträger gut in die an die beiden Elektroden angrenzenden Ladungsträgertransportschichten injiziert werden. Energetische Barrieren für das Injizieren der Ladungsträger, nämlich von Löchern und Elektronen, sollen deshalb möglichst klein sein. In üblichen organischen lichtemittierenden Dioden, die nicht über dotierte Ladungsträgertransportschichten verfügen, ist es notwendig, die ITO-Grundelektxode geeignet zu behandeln, um beispielsweise die Injektion von Löchern aus der Grundelektrode in die angrenzende Ladungsträgeriransportschicht erheblich zu verbessern. Diese Behandlung wird beispielsweise mit einem Sauerstoff- oder UV-Qzon-Plasma ausgeführt. Weitere Lösungsvorschläge verwenden Zwischenschichten aus polymerisierten, fluorierten Kohlenstoffverbindungen oder andere organische Löcherinjektionsschichten. Dünne Ladungsträgerinjektionsschichten aus Molybdän-Oxid oder Gold oder dergleichen kommen ebenfalls zum Einsatz.

Eine wesentliche Verbesserung der Injektion von Ladungsträgern aus den Elektroden in den organischen Bereich des lichtemittierenden Bauteils wird mit Hilfe der elektrischen Dotierung von Ladungsträgertransportschichten erreicht. Es treten dann insbesondere keine Spannungsverluste an den Grenzflächen auf. Die sonst vorgesehene, zusätzliche ITO-Behandlung für die Verbesserung der Löcherinjektion kann dann entfallen.

### Zusammenfassung der Erfindung

Aufgabe der Erfindung ist es, ein effizientes und langlebiges organisches lichtemittierendes Bauteil und ein Verfahren zum Herstellen zu schaffen, die ein materialsparendes und kostengünstiges Herstellen unterstützen, insbesondere hinsichtlich der Ausbildung einer strukturierten Grundelektrode.

Diese Aufgabe wird erfindungsgemäß durch ein organisches lichtemittierendes Bauteil nach dem unabhängigen Anspruch 1, ein Verfahren zum Herstellen nach dem unabhängigen Anspruch 15 sowie ein Artikel nach dem unabhängigen Anspruch 25 gelöst. Vorteilhafte Ausgestaltungen der Erfindung ergeben sich aus den abhängigen Unteransprüchen.

Mit dem vorgegebenen Brechungsindex, der hohen Transparenz und der Ausnutzung von Streueffekten ist eine effiziente Lichtauskopplung bei dem organischen lichtemittierenden Bauteil gewährleistet. Die Ausbildung der Grundelektrode ohne Bindemittel begünstigt eine Porosität innerhalb der Grundelektrodenschicht. Die Materialporosität führt zum einen zu Streueffekten und resultiert zum anderen in einem verminderten Brechungsindex von n<1,8 des effektiven Mediums zur Vermeidung von Lichtleitmoden (*"waveguiding modes"*) in der Grundelektrode, sodass das im sichtbaren Bereich erzeugte Licht besser aus dem Bauteil ausgekoppelt wird. Darüber hinaus weist die ohne Bindemittel ausgebildete poröse Grundelektrode eine hohe Transparenz auf. Auf diese Weise kann die Effizienz der Lichtemission des organischen lichtemittierenden Bauteils gesteigert werden. Die vom Betrachtungswinkel leicht abhängige Emissionswellenlänge, die sich normalerweise in einer Verschiebung zu kürzeren Wellenlängen äußert, wird durch die erzeugte Porosität ebenso unterbunden.

Der Effekt der Lichtleitmoden spielt in derartigen Bauteilen dann eine Rolle, wenn die Schichtdicken in der Größenordnung der Wellenlänge des erzeugten Lichtes liegen und darüber hinaus Oberflächen von aneinandergrenzenden Schichten einen wesentlichen Brechungsindexunterschied aufweisen, wie dieses beispielsweise an der Grenze zwischen dem organischen Bereich (typischer Brechungsindex n = 1,7) und einer gewöhnlichen ITO-Grundelektrode (n = 2,2) oder der Grenze zwischen einer solchen ITO-Grundelektrode (n = 2,2) und einem Glassubstrat (n = 1,5) der Fall ist. Aufgrund von Totalreflexion an den Grenzflächen zur ITO-Grundelektrode ist es in einer solchen Anordnung möglich, dass ein Anteil der Lichtmoden in der Grundelektrode geführt wird, welcher dann nicht direkt in Vorwärtsrichtung aus dem Glassubstrat ausgekoppelt wird, sondern entweder absorbiert wird oder an den Kanten der Grundelektrode austritt. Dieser Effekt könnte zwar beispielsweise dadurch vermieden werden, dass eine ITO-Grundelektrode mit geringer Schichtdicke vorgesehen wird, beispielsweise mit einer Schichtdicke von etwa 20 nm. Allerdings ist die elektrische Leitfähigkeit einer solchen ITO-Grundelektrode zu gering. Da die Ausbildung einer Grundelektrode mit einem Brechungsindex von n < 1,8 vorgesehen ist, werden Lichtleitmoden innerhalb der Grundelektrodenschicht unterdrückt.

In Kombination mit den weiteren Merkmalen wird mit der Ausbildung einer gut leitfähigen Grundelektrode aus transparentem leitfähigen Oxid, deren Flächenwiderstand kleiner 500 Ω/Quadrat beträgt, zusätzlich ein geringer Zuleitungswiderstand gewährleistet. Werden außerdem hohe Leckströme vermieden, welche zu elektrischen Verlusten innerhalb der Bauteil beitragen, so wird es möglich, effiziente, langlebige organische lichtemittierende Bauelemente herzustellen. Daher wird gefordert, dass in einer Strom-Spannungscharakteristik der Anordnung bei einer an die Anordnung angelegten Spannung von etwa -3 V ein Sperrstrom kleiner als etwa 10⁻² mA/cm² ist.

Unter langlebigen OLEDs werden im Sinne der vorliegenden Anmeldung organische lichtemittierende Dioden verstanden, deren Lebensdauern in typischen Anwendungsbereichen für bestimmte Helligkeiten (etwa 500 cd/m² 1000 Stunden übersteigt. Die Lebensdauer wird als die Zeitdauer definiert, bis die Helligkeit aufgrund von Degradationsprozessen auf 50 % des Ausgangswertes abgefallen ist.

Es ist vorgesehen, die Grundelektrode aus einer Dispersion aufzubringen. Der Begriff Dispersion bezeichnet im Sinne der vorliegenden Anmeldung ein Gemenge aus mindestens zwei Stoffen, die sicht nicht oder kaum ineinander lösen oder chemisch miteinander verbinden. Hierbei wird ein Stoff möglichst fein in einem anderen Stoff, nämlich einem sogenannten Dispersionsmittel, verteilt. Die einzelnen Phasen können deutlich voneinander abgegrenzt werden und in der Regel durch physikalische Methoden wieder voneinander getrennt werden. Es werden Dispersionen nach Art des Aggregatzustandes der beteiligten Stoffe und nach Teilchengröße des dispergierten Stoffes unterschieden. Werden Teilchen eines Feststoffes in einer Flüssigkeit dispergiert, so spricht man von einer Suspension. Es können sogenannte Dispergiermittel beigemischt werden, die eine bessere Verteilung des Stoffes im Dispersionsmittel bewirken, indem beispielsweise die Benetzbarkeit oder eine erhöhte elektrostatische Absto-ßung der zu dispergierenden Partikel erzielt werden.

Die Grundelektrodensehicht ist bindemittelfrei ausgeführt. Der Begriff Bindmittel ist im Sinne der vorliegenden Anmeldung ein Sammelbegriff für Produkte, die gleich- oder verschiedenartige Stoffe miteinander verbinden. Je nach Anwendung werden anorganische, organische, natürliche oder synthetisierte Bindemittel. Das Abbinden erfolgt mittels physikalischen Trocknen, Erstarren oder starken Viskositätsanstieg, chemische Reaktion oder Hydratisierung.

Optische Bauelemente werden im Sinne der vorliegenden Anmeldung als hocheffizient eingestuft, wenn insbesondere die ohmschen Verluste in der Anordnung minimiert sind, zum Beispiel bei einem geringen elektrischen Widerstand der Elektroden und der Ladungsträgertransportschichten sowie die günstigsten optischen Bedingungen für die Lichtemission oder - auskopplung erfüllt werden.

In einer zweckmäßigen Ausgestaltung der Erfindung ist vorgesehen, dass das Grundelektrodenmaterial von Nanopartikeln elektrisch leitfähiger Materialien gebildet ist. Nanopartikel sind Partikel, die einen Durchmesser von 1 nm bis 999 nm aufweisen. Partikelgrößenverteilungen können mittels dynamischer Lichtstreuung, beispielsweise dem Gerät Typ LB550 der Firma Horiba, gemessen werden. Bevorzugt werden Nanopartikel solange dispergiert, bis sie eine mittlere Partikelgröße aufweisen, die zumindest kleiner als die aufzubringende Schichtdicke ist. Hinsichtlich der Größenverteilung der Partikel innerhalb der Dispersion werden keine Einschränkungen getroffen. Dies bedeuten insbesondere, dass keine modalen Mischverhältnisse bestimmter Partikelgrößen bevorzugt erzeugt werden müssen, sodass der Herstellungsprozesses der zu verwendenden Nanopartikel bzw. einer daraus bestehenden Dispersion vereinfacht wird.

Bei einer vorteilhaften Ausgestaltung der Erfindung kann vorgesehen sein, dass das Grundelektrodenmaterial ein Material aus wenigstens einer Materialklasse ausgewählt aus der folgenden Gruppe von Materialklassen ist: ternäres Materialsystem wie In₂O₃:Sn (ITO), SnO₂:Sb (ATO), SnO₂:F, ZnO:Al, ZnO:In, Zn-Sn-O, Mg-In-O, Ga-In-O, Zn-In-O; quaternäres Materialsystemen wie Zu-In-Sn-O (ZITO), Zn-In-Li-O, chemisch modifizierte Variante des ternären Materialsystems, chemisch modifizierte Variante des quarternären Materialsystems, physikalisch modifizierte Varianten des ternären Materialsystems, physikalisch modifizierte Varianten des quarternären Materialsystems und Gemische hieraus.

Eine bevorzugte Fortbildung der Erfindung kann vorsehen, dass die Grundelektrodenschicht eine Schichtdicke zwischen etwa 0,05 µm und etwa 20 µm, bevorzugt zwischen etwa 0,1 µm und etwa 2 µm aufweist. Insbesondere bei der Verwendung einer gedruckten Grundelektrode aus ITO ergibt sich der Vorteil, dass die Abhängigkeit der Effizienz des Bauteils von der Schichtdicke des organischen Schichtbereiches mit zunehmender ITO-Schicktdicke nahezu verschwindet. Dies ermöglicht ein großes Prozessfenster für die Schichtdicken organischer Ladungsträgertransportschichten. Ebenso kann für einen sogenannten *"unified RGB-Stack",* bei dem für alle drei Farben der identischen Schichtaufbau mit gleichen Schichtdicken zum Einsatz kommt, auf einfache Weise eine generalisierte Struktur angewandt werden, die qualitativ hohe Kenndaten erzielt. Prozesstechnisch ergibt sich hierbei also eine vereinfachte Strukturierung und Maskierung der organischen Schichten für mehrfarbige RGB-Strukturen.

Eine Weiterbildung der Erfindung kann vorsehen, dass die Gnaidelektrodenschicht eine RMS-Rauhigkeit im Bereich von wenigstens etwa 2 nm bis höchstens etwa 20 nm und bevorzugt im Bereich von höchstens etwa 10 nm aufweist. Untersuchungen haben gezeigt, dass entgegen den Erwartungen langlebige, hocheffiziente organische lichtemittierende Bauelemente hergestellt werden konnten. Im Stand der Technik wurde bisher davon ausgegangen, dass die Grundelektrode besonders glatt sein muss, also mit <1 nm RMS herzustellen ist.

Bei einer vorteilhaften Ausgestaltung der Erfindung kann vorgesehen sein, dass der Flächenwiderstand der Grundelektrodenschicht kleiner als etwa 100 Ω/ Quadrat ist.

Eine vorteilhafte Ausführungsform der Erfindung sieht vor, dass der optische Brechungsindex der Gnmdelektrodenschicht kleiner als etwa 1,5 ist. Da den obigen Erläuterungen entsprechend geführte Lichtmoden innerhalb des Bauelements vermieden werden sollen, wird hier bevorzugt die Ausbildung einer Grundelektrode mit einem Brechungsindex von n<1,5 vorgesehen, weil dann zusätzlich keine Totalreflexion des einfallenden Lichtes, welches im organischen Schichtbereicht emittiert wird, an der Grenzfläche Crundelektrode/Glassubstrat (typisch n = 1,5) stattfinden kann. Somit treten höchstens noch Lichtleitmoden innerhalb des (Glas)Substrates auf, die jedoch mit herkömmlichen Auskoppelmethoden unterbunden werden können, zum Beispiel mittels aufgerauhter Substratunterseite, Auskoppelfolien oder dergleichen, sodass dann auch dieses Licht abgestrahlt wird.

Bevorzugt sieht eine Fortbildung der Erfindung vor, dass die Grundelektrodenschicht Licht, welches in dem organischen Schichtbereich erzeugt wird, streut und zu diesem Zweck mit einer Materialporosität zwischen etwa 1 % und etwa 99 %, bevorzugt zwischen etwa 20 % und etwa 60 % gebildet ist. Ausmaß und Qualität der Materialporosität können durch Wahl geeigneter Prozessparameter beim Ausbilden der Grundelektrode beeinflusst werden. So hat das gewählte Beschichtungsverfahren Einfluss auf die Packungsdichte der Partikel aus elektrisch leitendem Oxid und damit die Porosität, zum Beispiel liefert Spincoating eine um etwa 10 % höheren Füllgrad als Inkjet-Drucken. Insbesondere ist es so möglich, eine Grundelektrode herzustellen, die trotz gewünschter Schichtdicke eine hervorragende Transparenz für das in dem lichtemittierenden Bereich erzeugte Licht aufweist. Die vom Betrachtungswinkel leicht abhängige Emissionswellenlänge, die sich normalerweise in einer Verschiebung zu kürzeren Wellenlängen äußert, wird durch die erzeugte Porosität ebenso unterbunden.

Bei einer zweckmäßigen Ausgestaltung der Erfindung kann vorgesehen sein, dass die Grundelektrodenschicht im Wellenlängenbereich von sichtbarem Licht ein Transmissionsvermögen von wenigstens 60 % und bevorzugt von wenigstens 80 % aufweist.

Eine bevorzugte Ausgestaltung der Erfindung sieht vor, dass der organische Schichtbereich zwischen der Grundelektrode und dem lichtemittierenden Bereich wenigstens eine Ladungsträger transportierende Schicht, die wahlweise elektrisch dotiert ist, mit einer Schichtdicke von wenigstens etwa 100 nm umfasst, mit der eine Oberflächenrauhigkeit der Grundelektrodenschicht zumindest teilweise ausgeglichen ist.

Eine vorteilhafte Ausführungsform der Erfindung sieht vor, dass die Anordnung gemäß mindestens einer Bauart ausgewählt aus der folgenden Gruppe von Bauarten gebildet ist: transparenter Aufbau; Licht durch die Deckelektrode emittierender Aufbau; Licht durch die Grundelektrode emittierender Aufbau; Aufbau mit einer Schichtanordnung mit einer nicht invertierten Struktur, bei dem die Grundelektrode eine Anode ist; und Aufbau mit einer Schichtanordnung mit einer invertierten Struktur, bei dem die Grundelektrode eine Kathode ist.

Bevorzugt sieht eine Fortbildung der Erfindung vor, dass der organischen Schichtbereich eine oder mehrere Schichten, die wahlweise mehrfach gebildet sind, ausgewählt aus der folgenden Gruppe von Schichten aufweist: elektrisch undotierte Ladungsträgertransportscbicht, elektrisch dotierte Ladungsträgertransportschicht wie p-dotierte und n-dotierte Ladungsträgertransportschicht, Blockschicht, elektrisch undotierte Ladungsträgerinjektionsschicht und elektrisch dotierte Ladungsträgerinjektionsschicht. Die Verwendung von dotierten Schichten bewirkt eine verbesserte Ladungsträgerinjektion in den organischen Bereich. Hierdurch wird darüber hinaus ermöglicht, dass größere Schichtdicken verwendet werden können, welche ihrerseits mögliche Oberflächenrauhigkeiten der Grundelektrode ausgleichen können. Im Fall von dotierten Ladungsträgertransportschichten wird die sehr gute elektrische Leitfähigkeit ausgenutzt. Hierdurch werden erhebliche Spannungsabfälle über schlecht elektrisch leitfähigen Schichten vermieden, wie dies bei der Verwendung von undotierten Materialien der Fall ist. Die elektrischen Eigenschaften (IV-Kennlinie) der OLED werden durch die Wahl von größeren Schichtdicken nicht beeinträchtigt. Werden allerdings Lichtinterferenzeffekte in der Schichtanordnung des lichtemittierenden Bauteils bei der Dimensionierung der Schichtdicken berücksichtigt, so können auf diese Weise Schichtdicken gewählt werden, die eine Verstärkung (konstruktive Interferenz) in gewünschten Wellenlängenbereichen des im Emissionsbereiches erzeugten Lichtes bewirken und damit zur Effizienzsteigerung führen.

Bei einer vorteilhaften Ausgestaltung der Erfindung kann vorgesehen sein, dass die Anordnung auf einem Trägermaterial ausgewählt aus der folgenden Gruppe von Trägermaterialien gebildet ist: Glas, biegsames Trägermaterial, metallisches Trägermaterial und Kunststoff.

Nachfolgend werden bevorzugte Ausgestaltungen des Verfahrens zum Herstellen des organischen lichtemittierenden Bauteils näher erläutert.

Bevorzugt sieht eine Fortbildung der Erfindung vor, dass die Grundelektrodenschicht mittels eines strukturierenden Verfahrens ausgewählt aus der folgenden Gruppe von strukturierenden Verfahren strukturiert aufgedruckt wird: Inkiet-Druck, Offsetdruck, Gravur- / Tiefdruck, Thermotransferdruck, Laserdruck, Flexodruck, Siebdruck und Tampondruck. Hierdurch ist es ermöglicht, dass Grundelektrodenmaterial ausschließlich in genau den Bereichen auf dem Substrat aufzubringen, die von einer gewünschten Struktur umfasst sind. So werden nur tatsächlich notwendige Mengen des Grundelektrodenmaterials auf dem Substrat aufgebracht. Mittels der Steuerung des Druckprozesses für das Grundelektrodenmaterial ist die Möglichkeit geschaffen, ein Layout der gedruckten Strukturen präzise in Form und Schichtdicke einzustellen. Maskierungen und/oder Lithographieschritte entfallen hiermit. Spezialanfertigungen mit geringen Stückzahlen sowie Einzelexemplare sind damit ohne großen zusätzlichen technischen Aufwand günstig herstellbar. Hierdurch ist außerdem eine einfache Skalierbarkeit der Fertigung hin zu großen Substratflächen für ein oder mehrere organische lichtemittierende Bauteile, beispielsweise organische lichtemittierende Dioden mit aufgedruckten Grundelektroden erreicht. Insbesondere ist eine Prozessierung in Vakuumanlagen, wie es beim Stand der Technik üblich ist, nicht notwendig, sodass Substrate in beliebigen Formaten und Formen für die Aufbringung des Gnmdelektrodenmaterials verarbeitet werden können.

Eine Weiterbildung der Erfindung kann vorsehen, dass die Grundelektrodenschicht nach dem nasschemischen Aufbringen aus der Dispersion des Grundelektrodenmaterials nachbehandelt wird.

Eine bevorzugte Weiterbildung der Erfindung sieht vor, dass die Grundelektrodenschicht beim Nachbehandeln bei einer Temperatur im Bereich zwischen etwa 200 °C und etwa 1500 °C, bevorzugt zwischen etwa 200 °C und etwa 800 °C und weiter bevorzugt zwischen etwa 300 °C und etwa 650 °C unter Gasatmosphäre gesintert wird.

Eine vorteilhafte Weiterbildung der Erfindung sieht vor, dass die Gasatmosphäre beim Sintern mindestens ein Gas ausgewählt aus der folgenden Gruppe von Gasen umfasst: Umgebungsluft, wenigstens ein Schutzgas wie Argon, CO₂, Stickstoff, Edelgas und anderes nicht-reaktives Gas wie perhalogenierte Kohlenwasserstoffe.

Bei einer zweckmäßigen Ausgestaltung der Erfindung kann vorgesehen sein, dass die Grundelektrodenschicht beim Nachbehandeln bei einer Temperatur im Bereich zwischen etwa 20 °C und etwa 500 °C und bevorzugt zwischen etwa 150 °C und etwa 400 °C unter einer weiteren, der Gasatmosphäre wahlweise gleich ausgebildeten Gasatmosphäre im Verhältnis 99,9:0,1 bis 0,1:99,9, formiert wird.

Eine Weiterbildung der Erfindung kann vorsehen, dass die weitere Gasatmosphäre beim Formieren mindestens ein Gas ausgewählt aus der folgenden Gruppe von Gasen umfasst: Wasserstoff und wenigstens ein Schutzgas wie Argon, CO₂, Stickstoff, Edelgas.

Die Nachbehandlung mittels Sintern oder Formieren schafft einen intensiven Kontakt der Nanopartikel und reduziert damit den Übergangswiderstand zwischen den Nanopartikeln. Dies wird durch eine geeignete Prozessführung erreicht, bei der die ursprüngliche Porosität und Packung der Nanopartikel weitestgehend bestehen bleibt, und indem nur im Anfangsbereich des Sinterregimes gearbeitet wird. Durch optimierte Aufheiz- und Abkühlzeiten beim Sintern und Formieren konnten Rissbildung in der Schicht und sonstige Störungen vermieden werden und gleichzeitig die Leitfähigkeit maximiert werden.

Bevorzugt sieht eine Fortbildung der Erfindung vor, dass der organische Schichtbereich ausschließlich aus aufgedampften niedermolekularen Schichten bestehend gebildet wird.

In einer zweckmäßigen Fortbildung der Erfindung ist vorgesehen, dass die Deckelektrode mittels Sputtern oder thermischen Verdampfen eines Deckelektrodenmaterials gebildet wird.

Bevorzugt sieht eine Fortbildung der Erfindung vor, dass das organische lichtemittierende Bauteil in einem Rolle-zu-Rolle Prozess hergestellt wird.

### Beschreibung von bevorzugten Ausführungsbeispielen der Erfindung

Die Erfindung wird im folgenden anhand von Ausführungsbeispielen unter Bezugnahme auf Figuren einer Zeichnung näher erläutert. Hierbei zeigen:
- Fig. 1: eine schematische Darstellung eines organischen lichtemittierenden Bauteils mit einer Schichtanordnung mit nicht-invertiertem Aufbau, bei dem eine gedruckte Grundelektrode als Anode ausgeführt ist;
- Fig. 2: eine schematische Darstellung eines organischen lichtemittierenden Bauteils mit einer Schichtanordnung mit nicht-invertiertem Aufbau, bei dem die gedruckte Grundelektrode als Anode ausgeführt ist, wobei eine elektrisch dotierte Ladungsträgertransportschichten, die an den Grundkontakt angrenzt, vorgesehen ist;
- Fig. 3: eine schematische Darstellung eines organischen lichtemittierenden Bauteils mit einer Schichtanordnung mit nicht-invertiertem Aufbau, bei dem die gedruckte Grundelektrode als Anode ausgeführt ist, wobei elektrisch dotierte Ladungsträgertransportschichten vorgesehen sind;
- Fig. 4: eine grafische Darstellung des Transmissionsvennögens eines gedruckten Grundkontaktes aus einer ITO-Dispersion in Abhängigkeit von der Wellenlänge;
- Fig. 5: eine grafische Darstellung für eine Diodenkennlinie j(V) einer OLED mit p- und n- dotierten Ladungsträgertransportschichten und einem gedruckten ITO-Grundkontakt;
- Fig. 6: eine grafische Darstellung für eine Helligkeitskurve L(V) einer roten OLED mit p- und n-dotierten Ladungsträgertransportschichten und einem gedruckten ITO-Grundkontakt;
- Fig. 7: eine grafische Darstellung für die StromeSizienz einer OLED mit p- und n-dotierten Ladungsträgertransportschichten und einem gedruckten ITO-Grundkontakt;
- Fig. 8: eine grafische Darstellung für das Elektrolumineszenz-Spektrum einer roten OLED mit p- und n-dotierten Ladungsträgertransportschichten und einem gedruckten ITO-Grundkontakt;
- Fig. 9: eine grafische Darstellung für Elektrolumineszenz-Spektren einer roten OLED mit p- und n-dotierten Ladungsträgertransportschichten und einem gedruckten ITO-Grundkontakt in Abhängigkeit vom Betrachtungswinkel;
- Fig. 10: eine grafische Darstellung der Intensität des abgestrahlten Lichts einer roten OLED mit p- und n-dotierten Ladungsträgertransportschichten und einem gedruckten ITO-Grundkontakt in Abhängigkeit vom Betrachtungswinkel (Polardiagramm);
- Fig. 11: eine grafische Darstellung für den Brechungsindex n und den Absorptionskoeffizienten k einer aus einer Dispersion gedruckten ITO-Grundelektrode in Abhängigkeit der Wellenlänge und
- Fig. 12: eine grafische Darstellung für eine Lebensdauermessung von roten OLEDs mit p- und n-dotierten Ladungsträgertransportschichten und einem gedruckten ITO-Grundkontakt bei Starthelligkeiten von etwa 2460 cd/m², 1720 cd/m² und 1100 cd/m², wobei eine doppel-logarithmische Darstellung zur Lebensdauerextrapolation bis 500 cd/m² gewählt ist.

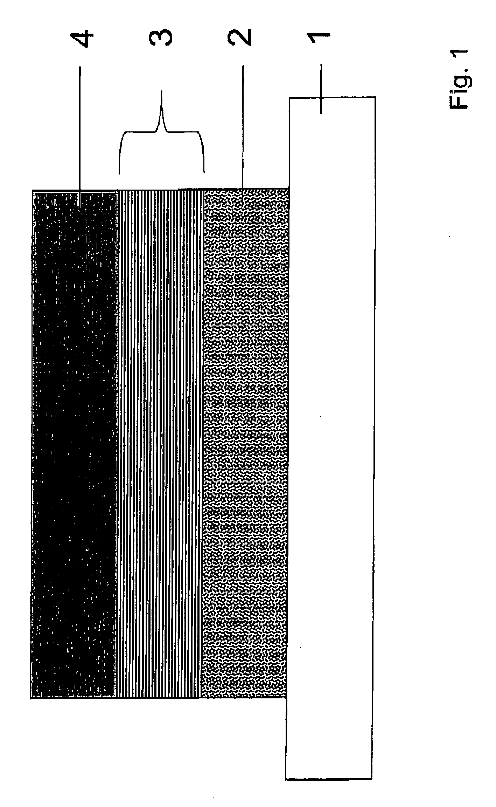

Fig. 1 zeigt eine schematische Darstellung eines organischen lichtemittierenden Bauteils in Ausführung als organische lichtemittierende Diode (OLED) mit einer Schichtanordnung mit nicht-invertiertem Aufbau.

Auf einem Substrat 1 ist eine Grundelektrode 2 aus Indium-Zinn-Oxid (ITO) aufgebracht. Auf die Grundelektrode 2 folgt ein Stapel 3 mit organischen Schichten. Den Abschluss bildet eine Deckelektrode 4. Das Substrat 1 dient als Trägermaterial, bei dem es sich in dem dargestellten Ausführungsbeispiel um Glas handelt. Die Grundelektrode 2 aus ITO ist als löcherinjizierende Elektrode (Anode) gebildet. Sie ist bindemittelfrei und transparent ausgeführt und weist eine Schichtdicke zwischen etwa 0,05 µm und 20 µm, bevorzugt zwischen etwa 0,1 µm und 2 µm auf. Der Brechungsindex der Schicht ist kleiner als 1,8. Die Oberflächenrauhigkeit beträgt zwischen 2nm und etwa 20 nm RMS, bevorzugt kleiner etwa 10nm RMS. Das Grundelektrodenmaterial ITO wurde aus einer Dispersion mit Hilfe eines Druckverfahrens aufgedruckt.

Der ITO-Grundkontakt für organische Leuchtdioden wird aus einer Dispersion auf das Substrat aufgedruckt. In Versuchen wurde der Anteil des ITOs, der Netzmittel und der Feuchthaltemittel systematisch variiert, um damit die Dispersion für das jeweilige Beschichtungsverfahren zu optimieren. Entscheidend für das Druckverhalten sind die Viskosität und Rheologie, das Zetapotential und die Oberflächenspannung.

Dabei werden zunächst zum Beispiel wässrige oder Lösungsmittel basierte Dispersionen von Nanopartikeln aus elektrisch leitenden Oxiden, zum Beispiel ITO, in einem strukturierenden Beschichtungsverfahren aufgebracht. Beispiele für strukturierende Beschichtungsverfahren sind insbesondere Offsetdruck, Tief-/Gravurdruck, Thermotransferdruck, Laserdruck, Flexodruck, Siebdruck, Tampondruck und Inkjet-Druck.

Danach schließt sich je nach verwendetem TCO, nämlich einem elektrisch leitfähigen Oxidmaterial, mit dem optisch transparente Schichten gebildet werden können, ein Sinterprozess an. Dieser kann zum Beispiel für ITO unter Atmosphäre oder Schutzgas wie zum Beispiel Stickstoff oder Argon bei 400 °C bis 600 °C für 30 min bis 5 h ablaufen. Abschließend erfolgt wahlweise eine Reduktion des Oberfilächensauerstoffsgehaltes (Formieren). Der Prozess erfolgt unter reinem Wasserstoff oder einem Gemisch aus Wasserstoff und Schutzgas (zum Beispiel Stickstoff oder Argon, Wasserstoffgehalt 99,9 % - 0,1 %) bei einem Gasstrom von statisch bis 1000 1/h für 10 min bis 4 h.

Es werden so zum Beispiel ITO-Schichten mit homogener Dicke, hoher Leitfähigkeit und hohem Transmissionsvermögen erhalten. Die so erzeugten ITO-Kontakte weisen außerdem eine Porosität von 20 % bis 60 % auf, gemessen mittels Röntgenfluoreszenzanalyse (RFA). Die oben beschriebene Nachbehandlung mittels Sintern und Formieren schafft einerseits einen intensiven Kontakt der Nanopartikel und reduziert damit den Übergangswiderstand zwischen den Nanopartikeln. Der gemessene Flächenwiderstand wird um mehrere Größenordnungen reduziert. Andererseits bleiben die ursprüngliche Packung der Nanopartikel und deren partikulärer Charakter weitestgehend erhalten. Dies wird durch eine geeignete Prozessführung erreicht, bei der die ursprüngliche Porosität und die Packung der Nanopartikel weitestgehend bestehen bleiben, und indem nur im Anfangsbereich des Sinterregimes gearbeitet wird. Durch optimierte Aufheiz- und Abkühlzeiten beim Sintern und Formieren konnten Rissbildung in der Schicht und sonstige Störungen vermieden werden und gleichzeitig die Leitfähigkeit maximiert werden.

Als Schutzgas sind insbesondere nutzbar: Kohlendioxid, Stickstoff, die Gruppe der Edelgase sowie nicht reaktiven Gase, wie zum Beispiel perhalogenierte Kohlenwasserstoffe verstanden.

Zur Herstellung der in dem Verfahren eingesetzten Zusammensetzung werden als TCO bevorzugt elektrisch leitfähige Nanopartikel, ausgewählt aus ternären Systemen wie zum Beispiel In₂O₃:Sn (ITO), SnO₂:Sb (ATO), SnO₂:F, ZnO:Al, ZnO:In, Zn-Sn-O, Mg-In-O, Ga-In-O, Zn-In-O, oder quaternären Systemen wie zum Beispiel Zn-In-Sn-O (ZITO), Zn-In-Li-O, oder chemisch und/oder physikalisch modifizierte Varianten dieser Nanopartikel, oder ein Gemisch aus diesen Nanopartikeln und/oder Systemen, verwendet.

In dem Verfahren kann als Dispersionsmittel für die Zusammensetzung zumindest eine organische, protische, aprotische, polare oder unpolare Flüssigkeit, oder eine anorganische Flüssigkeit eingesetzt werden. Bevorzugt kann in dem erfindungsgemäßen Verfahren als Dispersionsmittel eine Säure, ein Glykol, ein Glykolether, C1- bis C8-Kohlenwasserstoffe, aromatische Kohlenwasserstoffe, aliphatische Kohlenwasserstoffe, aromatisch oder aliphatisch halogenierte Kohlenwasserstoffe, S-, P-, oder Si-heterosubstituierte Kohlenwasserstoffe, oder überkritische Lösemittel, oder Silicone, oder organische Verbindungen, ausgewählt aus Mono-, Oligo-, Polymere, Farbstoffe, leitfähige organische Verbindungen, nichtoxidische anorganische Verbindungen, metallorganische Verbindungen, reaktive Zwischenstufen bildende organische Verbindungen, ausgewählt aus Benzoylperoxid, Azo-bis-isobutyronitril, oder einem Gemisch dieser organischen Verbindungen, oder ein Gemisch aus diesen Verbindungen verwendet werden, wobei die Dispersionsmittel auch im jeweiligen überkritischen Druck- und Temperaturbereich verwendet werden können. Besonders bevorzugt kann in dem erfindungsgemäßen Verfahren als Dispersionsmittel ein C1- bis C12-Alkohol, Ester, oder Ether verwendet werden.

Der Stapel 3 organischer Schichten umfasst in dem dargestellten Ausführungsbeispiel die folgenden Schichten:
- Löcherinjektionsschicht aus CuPc (Kupfer-Phthalocyanin) oder Starburst-Derivat mit einer Schichtdicke zwischen etwa 5 nm und etwa 1000 nm, bevorzugt zwischen etwa 5 nm und 200 nm;
- Löchertransportschicht aus TPD (Triphenyldiamin) mit einer Schichtdicke zwischen etwa 5nm und etwa 1000 nm;
- löcherseitige Blockschicht zum Verhindern einer Exzitonendiffusion aus einer lichtemittierenden Schicht und zum Verhindern einer Ladungsträger-Leckage aus der lichtemittierenden Schicht aus alpha-NPB (bis-naphtyl-phenylamino-biphenyl) mit einer Dicke zwischen etwa 2 nm und etwa 50 nm, bevorzugt zwischen etwa 5 nm und etwa 30 nm;
- lichtemittierende Schicht aus CBP (Carbozol-Derivate) mit Beimischung eines Emittermaterials in Form phosphoreszenter Tripiet-Emitter wie Eridium-tris-phenylpyridin Ir(ppy)₃ oder Alq₃ (tris-quinolinato-alwninium) mit einer Dicke zwischen etwa 5 nm und etwa 100 nm, bevorzugt zwischen etwa 10 nm und etwa 30 nm;
- elektronenseitige Blockschicht aus BCP (Bathocuproine) mit einer Dicke zwischen etwa 2 nm und etwa 50 nm, bevorzugt zwischen etwa 5 nm und etwa 30 nm;
- Elektronentransportschicht aus Alq₃ (tris-quinolinato-aluminium) mit einer Dicke zwischen etwa 10 nm und etwa 500 nm, bevorzugt zwischen etwa 20 nm und etwa 200 nm;
- Elektroneninjektionsschicht aus anorganischem Lithiumfluorid (LiF) mit einer Schichtdikke zwischen 0,5 nm und 5 nm.

Die elektroneninjizierende Deckelektrode 4 ist aus einem Metall mit einer niedrigen Austrittsarbeit, beispielsweise Aluminium. Sie kann aber auch aus elektrisch leitenden Oxiden (TCOs, zum Beispiel ITO), Metallen wie Ba, Ca, Au, Ag, Cr, Mo, Ta, Ti, Ni, Pt, Zn, Zu, Legierungen / Mischungen der vorstehenden Metalle, Metalloxiden wie Ni_{y}Oₓ, Ti_{y}Oₓ, Pd_{y}Od, Pt_{y}Oₓ, Al_{y}Oₓ, Zn_{y}Oₓ, Ta_{y}Oₓ, MgO, Ca_{y}Oₓ, V_{y}Oₓ, Cu_{y}Oₓ, Metallnitriden wie Ti_{y}Nₓ, Ni_{y}Nₓ, Pd_{y}Nₓ, Pt_{y}Nₓ, Ga_{y}Nₓ und mit einer Dicke von wenigstens etwa 10 nm gebildet sein.

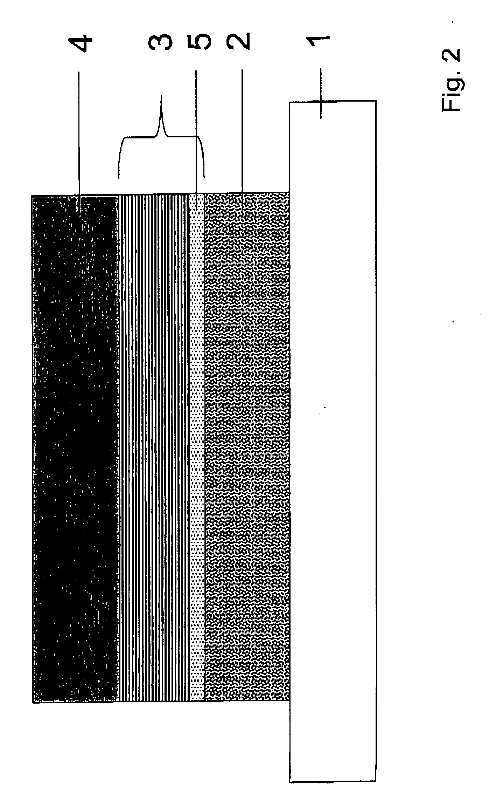

Fig. 2 zeigt eine schematische Darstellung eines organischen lichtemittierenden Bauteils in einer Ausführung als organische lichtemittierende Diode (OLED) mit einer Schichtanordnung mit nicht-invertiertem Aufbau, bei der die Grundelektrode eine Anode ist.

Das Substrat 1, die Grundelektrode 2 sowie die Deckelektrode 4 sind dem Ausführungsbeispiel in Fig. 1 entsprechend gebildet. Zusätzlich umfasst das organische lichtemittierende Bauteil in Fig. 2 eine p-dotierte löcherinjizierende und transportierende Schicht 5 mit einer Schichtdicke zwischen etwa 5 nm und etwa 1000 nm, bevorzugt zwischen etwa 40 nm und etwa 200 nm. In ein Matrixmaterial m-MTDATA ist zur elektrischen Dotierung ein Akzeptormaterial F4-TCNQ als Dotand eingebracht. Die elektrische Dotierung derartiger Ladungsträgertransportschichten zur Verbesserung der elektrischen Leitfähigkeit für durch die Transportschicht zu transportierende Ladungsträger ist als solche bekannt.

Der Stapel 3 organischer Schichten weist in dem AusiUhrungsbeispiel nach Fig. 2 den folgenden Aufbau auf:
- löcherseitige Blockschicht aus alpha-NPB mit einer Dicke zwischen etwa 2 nm und etwa 50 nm, bevorzugt zwischen etwa 5 nm und etwa 30 nm;
- Lichtemittierende Schicht aus TCTA mit Beimischung eines Emittermaterials in Form von Ir(ppy)₃ mit einer Schichtdicke zwischen etwa 5 nm und etwa 100 nm, bevorzugt zwischen etwa 10 nm und etwa 30 nm;
- elektronenseitige Blockschicht aus BCP mit einer Dicke zwischen etwa 2 nm und etwa 50nm, bevorzugt zwischen etwa 5 nm und etwa 30 nm;
- Elektronentransportschicht aus Alq₃ mit einer Dicke zwischen etwa 10 nm und etwa 500 nm, bevorzugt zwischen etwa 20 nm und etwa 200 nm;
- Elektroneninjektionsschicht aus anorganischem Lithiumfluorid (LiF) mit einer Schichtdikke zwischen 0,5 nm und 5 nm.

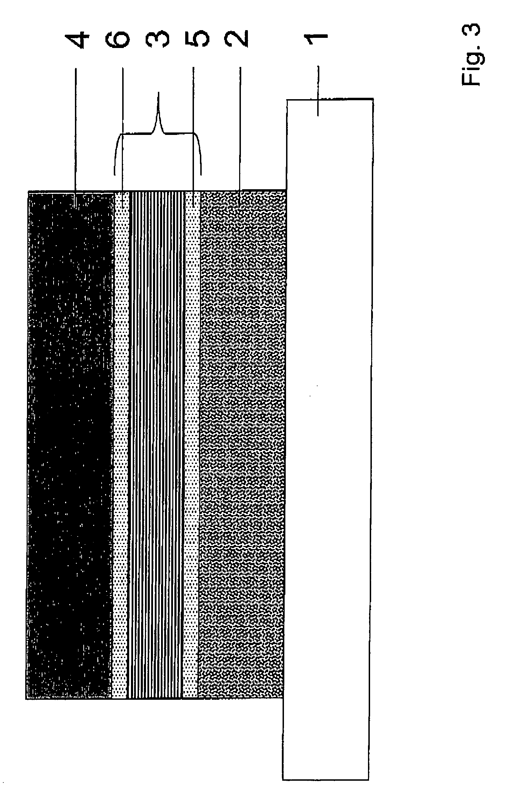

Fig. 3 zeigt eine schematische Darstellung eines organischen lichtemittierenden Bauteils in Ausführung als eine organische lichtemittierende Diode (OLED) mit einer Schichtanordnung mit nicht-invertiertem Aufbau, bei dem die Grundelektrode eine Anode ist. Es sind p- und n-dotierte Ladungsträgertransportschichten vorgesehen, die zur Verbesserung der elektrischen Leitfähigkeit eine Dotierung aufweisen.

Das Substrat 1, die Grundelektrode 2 aus ITO, der Stapel 3 organischer Schichten, die Deckelektrode 4 sowie die p-dotierte Löcher injizierende und transportierende Schicht 5 sind dem Ausführungsbeispiel in Fig. 2 entsprechend gebildet.

Zusätzlich ist bei dem Ausführungsbeispiel in Fig. 3 eine n-dotierte Elektronen injizierende und transportierende Schicht 6 mit einer Dicke zwischen etwa 10 nm und etwa 500 nm, bevorzugt zwischen etwa 20 nm und etwa 200 nm gebildet. In einem Matrixmaterial BPhen (Bathophenanthrolin) ist als elektrisches Dotierungsmaterial Cäsium zur Verbesserung der elektrischen Leitfähigkeit eingebettet. Die Dotierung einer derartigen Ladungsträgcrtransportschicht zur Verbesserung der elektrischen Leitfähigkeit ist als solche in verschiedenen Ausführungsformen bekannt.

Im Unterschied zu den in den Fig. 1 bis 3 dargestellten Ausführungsformen kann das organische lichtemittierende Bauteil in der Ausführung als organische lichtemittierende Diode (OLED) auch mit einer Schichtanordnung mit invertiertem Aufbau gebildet werden, bei der die Grundelektrode als Kathode und die Deckelektrode als Anode ausgeführt sind. In diesem Fall grenzt die Elektronen transportierende Schicht an die gedruckte ITO-Grundelektrode. Auch in dieser Ausführungsform können dotierte Ladungsträgertransportschichten zur Verbesserung der Leistungsparameter des Bauteils vorgesehen sein.

Sind die Grundelektrode 2 und die Deckelektrode 4 als transparente Elektroden ausgeführt, so ist ein transparentes organisches lichtemittierendes Bauteil hergestellt. Eine solche Transparenz wird typischerweise mittels Verwendung von dünnen Metallschichten erreicht, beispielsweise aus Silber, Gold, Aluminium, Magnesium, Kalzium oder dergleichen oder einer Kombination hieraus. Es können auch Einzelschichten oder mehrschichtige Ausführungen mit transparenten leitfähigen Oxiden verwendet werden, beispielsweise ITO (Indium-Zinn-Oxid) oder IZO (lndium-Zink-Oxid). Darüber hinaus können Antireflexionsbeschichtungen vorgesehen sein, um die Lichtauskopplung aus dem organischen lichtemittierenden Bauteil zu verbessern.

Nachfolgend werden bevorzugte Ausgestaltungen in Verbindung mit dem Stapel 3 organischer Schichten näher erläutert.

Die Eigenschaften organischer Materialien in dem Stapel 3 organischer Schichten können mittels energetischer Niveaus näher beschrieben werden, insbesondere unter Bezugnahme auf das niedrigste unbesetzte Molekülorbital (LUMO) und das höchste besetzte Molekülorbital (HOMO). Löchertransportschichten haben üblicherweise HOMOs im Bereich von 4,5 bis 5,5 eV unter Vakuumniveau und LUMOs im Bereich von 1,5 bis 3 eV. Die organischen Materialien für den lichtemittierenden Bereich weisen üblicherweise HOMOs im Bereich von 5 bis 6,5 eV und LUMOs im Bereich von 2 bis 3 eV auf. Die organischen Materialien für Elektronentransportschichten haben üblicherweise HOMOs im Bereich von 5,5 bis 6,8 eV und LUMOs im Bereich von 2,3 bis 3,3 eV. Die zugehörigen Austrittsarbeiten für die Materialien der Elektroden liegen im Bereich von 4 bis 5 eV im Fall der Anode und von 3 bis 4,5 eV im Fall der Kathode.

Nachfolgend werden nun die zur n- oder p-Dotierung nutzbaren Materialien näher erläutert.

Bei dem Donatormaterial (n-Dotand) handelt es sich um ein Molekül oder ein neutrales Radikal mit einem HOMO-Niveau von kleiner als 3,3 eV, bevorzugt von kleiner als 2,8 eV und weiter bevorzugt von kleiner als 2,6 eV. Das HOMO-Niveau des Donatoren kann aus cyclovoltammetrischen Messungen des Oxidationspotentials bestimmt werden. Der Donator soll ein Oxidationspotential aufweisen, welches gegenüber Fc / Fc+ (Ferrocen / Ferrocenium Redoxpaar) kleiner oder gleich etwa -1,5 V, vorzugsweise kleiner oder gleich etwa -2,0 V, weiter bevorzugt kleiner oder gleich etwa -2,2 V ist. Die molare Masse des Donators liegt zwischen 100 und 2000 g/mol, bevorzugt zwischen 200 und 1000 g/mol. Die molare Dotierkonzentration beträgt zwischen 1:1000 (Akzeptormolekül : Matrixmolekül) und 1:2, bevorzugt zwischen 1:100 und 1:5 und weiter bevorzugt zwischen 1:100 und 1:10.

Bei dem Akzeptormolekül (p-Dotand) handelt es sich um ein Molekül oder ein neutrales Radikal mit einem LUMO-Niveau von größer als 4,5 eV, bevorzugt von größer als 4,8 eV, weiter bevorzugt von größer als 5,04 eV. Das LUMO-Niveau des Akzeptoren kann aus cyclovoltrammetrischen Messungen des Reduktionspotentials bestimmt werden. Der Akzeptor weist ein Reduktionspotential auf, welches gegenüber Fc / Fc+ größer oder gleich etwa -0,3 V, vorzugsweise größer oder gleich etwa 0,0 V und weiter bevorzugt größer oder gleich etwa 0,24 V ist. Die molare Masse des Akzeptors liegt zwischen 100 und 2000 g/mol, bevorzugt zwischen 200 und 1000 g/mol. Die molare Dotierungskonzentration beträgt zwischen 1:1000 (Akzeptormolekül : Matrixmolekül) und 1:2, bevorzugt zwischen 1:100 und 1:5 und weiter bevorzugt zwischen 1:100 und 1:10.

Die Schichten des Stapels 3 organischer Schichten werden in einem Vakuumverfahren mittels Aufdampfen abgeschieden, zum Beispiel VTE (*"Vacuum Thermal Evaporation"*) oder OVPD (*"Organic Vapour Phase Deposition").* Des weiteren können Vakuum-Spray-Verfahren zum Einsatz kommen. Eine weitere Abscheidungsart umfasst den thermisch oder optisch induzierten Übertrag des Materials von einem Trägersubstrat auf das eigentliche Substrat, zum Beispiel LITI *("Laser Induced Thermal Imaging").*

Die dotierten Schichten in dem Stapel 3 organischer Schichten werden im Vakuum mittels Mischverdampfung aus zwei unabhängig geregelten Verdampfungsquellen, nämlich einer Verdampfungsquelle für das Matrixmaterial und einer Verdampfungsquelle für das Dotierungsmaterial, hergestellt. Sie können alternativ auch mittels Interdiffusion aus einer Dotandenschicht in die Matrixmaterialschicht entstehen, wobei die beiden Materialien nacheinander im Vakuum aufgedampft werden. Die Interdiffusion kann thermisch gesteuert sein.

Nachfolgend werden weitere Ausführungsformen zum Ausbilden einer Grundelektrode aus ITO des organischen lichtemittierenden Bauelementes näher beschrieben. Eine Dispersion aus ITO, die dann zum Ausbilden der Grundelektrode mittels Inkjet-Drucken verwendet wird, kann auf verschiedene Weise hergestellt werden. Im Folgenden werden drei Ausführungsbeispiele für die Herstellung der ITO-Dispersion erläutert.

Einer Ausgestaltung entsprechend wird die ITO-Dispersion unter Verwendung eines Gerätes "Dispermat CA" der Firma VMA-Getzmann GmbH erzeugt. Ein Dispergierbehälter hat ein Volumen von einem Liter. Als Mahlkugeln werden YTZ-Kugeln auf Yttriumbasis mit einem Durchmesser von 0,65 mm genutzt. Die Dispergierzeit beträgt etwa zwei Stunden. Falls erforderlich kann die Temperatur eingestellt werden.

Als Edukte werden folgende Materialkombinationen bevorzugt:

| | |
|---|---|
| a) | 300 g *AdNano*^{®} ITO (Hersteller Degussa GmbH) |
| | 10 g 2-[2-(2-Methoxyethoxy)ethoxy]acidacid |
| | 290 g Ethanol: Isopropoxyethanol im Verhältnis 3:1 |
| | |
| b) | 200 g *AdNano*^{®} ITO (Hersteller Degussa GmbH) |
| | 25,3 g 2-[2-(2-Methoxyethoxy)ethoxy]acidacid |
| | 374,7g Ethanol |
| | 50 g 1,2 Propandiol |
| | |
| c) | 250 g *AdNano*^{®} ITO (Hersteller Degussa GmbH) |
| | 10g 2-[2-(2-Metktoxyethoxy)ethoxy]acidacid |
| | 216 g Ethanol |
| | 104 g 1,2 Propandiol |
| | |
| d) | 250 g *AdNano*^{®} ITO (Hersteller Degussa GmbH) |
| | 10 g 2-[2-(2-Methoxyethoxy)ethoxy]acidacid |
| | 216 g Ethanol: Methyethylketon im Verhältnis 1:1 |
| | |
| e) | 125 g *AdNano*^{®} ITO (Hersteller Degussa GmbH) |
| | 375 g Wasser |
| | 18,75 g CT231 von Air-Products |
| | |
| f) | 200 g *AdNano*^{®} ITO (Hersteller Degussa GmbH) |
| | 100 g Degalan P 26 Röhm |
| | 700 g Methylethylketon |
| | |
| g) | 200 g *AdNano*^{®} ITO (Hersteller Degussa GmbH) |
| | 100 g Degalan P 26 Röhm |
| | 700 g Ethylacetat |
| | |
| h) | 124g *AdNano*^{®} ITO (Hersteller Degussa GmbH) |
| | 5 g Walocel MT 10000GO |
| | 875 g Wasser |
| | |
| i) | 30g *AdNano*^{®} ITO (Hersteller Degussa GmbH) |
| | 2,5g Walocel MT 10000GO |
| | 67,5 g Isopropoxyethanol |
| | |
| j) | 250g *AdNano*^{®} ITO (Hersteller Degussa GmbH) |
| | 20 g Disperbyk 163 |
| | 210 g Ethylacetat |
| | |
| k) | 250 g *AdNano*^{®} ITO (Hersteller Degussa GmbH) |
| | 10g Disperbyk 180 |
| | 216 g Propandiol |

Zu Beginn wird das ITO-Gemisch zehn Minuten mit einem Ultaturax mit 4000 U/min vordispergiert.

Vor dem Einfüllen der ITO-Dispersion, sind die maximale und die minimale (etwa 2 cm oberhalb der minimalen Höhe) Betriebshöhe einzustellen. Die YTZ Kugeln (40 ml) werden in einen Mahlkorb gefüllt. Die Öffnung einer Tauchmühle sollte gut bedeckt sein, da sonst der optimale Dispergierfluss nicht gewährleistet ist. Die Rotationsgeschwindigkeit wird nun auf 2200 U/min eingestellt.

Während der gesamten Dispergierung wird das Gemisch auf 8 bis 11 °C gekühlt. Nach zwei Stunden wird eine Probe zur Bestimmung der Partikelgrößenverteilung mit Hilfe des Geräts Typ LB550 der Firma Horiba entnommen. Wenn der D50-Wert bei etwa 100 nm liegt, wird die Dispergierung beendet. Im Anschluss wird das Gemisch für zehn Minuten mit 4000 U/min zentrifugiert. Danach erfolgt eine Filtration der ITO-Dispersion mittels 0,5 µm Pal Filter und die Partikelgrößenverteilung wird nochmals mit dem Horiba-Gerät bestimmt. Vor und nach der Filtration wurden folgende Messwerte ermittelt:

| | |
|---|---|
| Vor der Filtration: | Nach der Filtration: |
| D50:100,9 nm | D50: 86,9 nm |
| D10: 69,4 nm | D10: 59,8 nm |
| D90: 135,9 nm | D90:116,3 nm |

Die Viskosität beträgt etwa 5 bis 10 mPa. Die Dispersion weist eine homogene dunkelblaue Färbung auf.

Einer alternativen Ausgestaltung entsprechend wird die ITO-Dispersion mittels Anwendung von Ultraschall hergestellt, zum Beispiel unter Verwendung eines Ultraschallfingers (TYP Dr. Hilscher UP 200S, Mikrospitze S7 Schallleistungsdichte 300 W/cm²). Als Edukte werden die oben genannten Materialkombinationen bevorzugt. Die Herstellung der Dispersion erfolgt mittels Ultraschalldispergierung mit anschließender Beurteilung der Teilchengröße (etwa 0,1 bis 0,2 µm) am Lichtmikroskop. Die Dauer der Ultraschallbehandlung beträgt 20 Minuten.

Einer weiteren Ausgestaltung entsprechend wird die ITO-Dispersion unter Verwendung einer Durchflusszelle hergestellt. In diesem Fall kommt zum Beispiel das Gerät UIP 1000 von Dr. Hilscher mit Sonotrode BS 34 zur Anwendung (Stimflächendurchmesser 34 mm, Schallleistungsdichte 95 W/cm²). Als Edukte werden wiederum bevorzugt die oben genannten Materialkombinationen verwendet.

Die Gemische werden im genannten Verhältnis in einem Becherglas mit einem Volumen von 11 gemischt und dann mittels Schlauchpumpe durch die Durchflusszelle gepumpt. Die gesamte Pumpzeit beträgt 75 min bei einer Amplitude von 100 %, wobei die Dispersion die ersten 15 min im Kreis gepumpt wird. Danach wird das Gemisch für eine Stunde von einem Becherglas in ein weiteres Becherglas gepumpt, um sicherzustellen, dass alle Partikel mindestens einmal eine Ultraschallbehandlung erfahren haben. Nach der Ultraschallbehandlung wird die Partikelgrößenverteilung mit Hilfe des Geräts Typ LB550 der Firma Horiba gemessen. Der Wert liegt nach 45 min typischerweise bei D50=115 nm und nach 75 min bei D50=76 nm.

Die hergestellte Dispersion des ITO wird dann mittels eines Druckers strukturiert auf ein gereinigtes Glassubstrat aufgedruckt. Hierbei kann zum Beispiel der Drucker PixDro LabP 150 der Firma Pixdro verwendet werden. Der genutzte Druckkopf besitzt folgende Parameter: Auflösung - Cross Scan 838,45 dpi / In Scan 846,67 dpi; Qualitätsfaktor 3; Schrittweite 32; Mask File QF3 1x1; Spannung 60; GAP 1.00; T Chuk 26,8 °C; Luftfeuchte 27% und Druckrichtung - Erste Richtung.

Nach dem Drucken werden die hierbei gebildeten Schichten für eine Stunde bei 100 °C getrocknet. Anschließend werden sie eine Stunde bei 550 °C in einem Muffelofen (C40) der Firma Nabertherm gesintert und danach zwei Stunden bei 300 °C in einem Stickstoff- / Wasserstoffgemisch 95:5 bei einem Gasstrom von 200 1/h formiert. Die Flächenwiderstände betragen nach dem Sintern:
Feld 1: 610 Ω/Quadrat, Feld 2: 602 Ω/Quadrat, Feld 3: 592 Ω/Quadrat,
und nach dem Formieren:
Feld 1: 58 Ω/Quadrat, Feld 2: 61 Ω/Quadrat, Feld 3: 63 Ω/Quadrat.

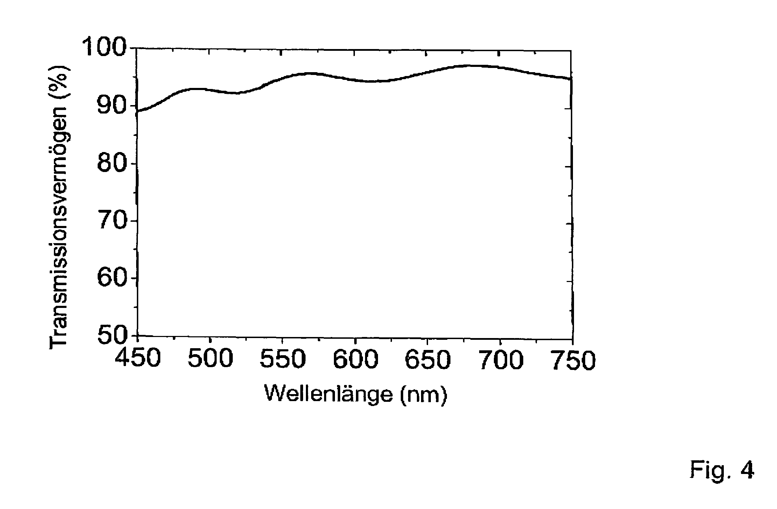

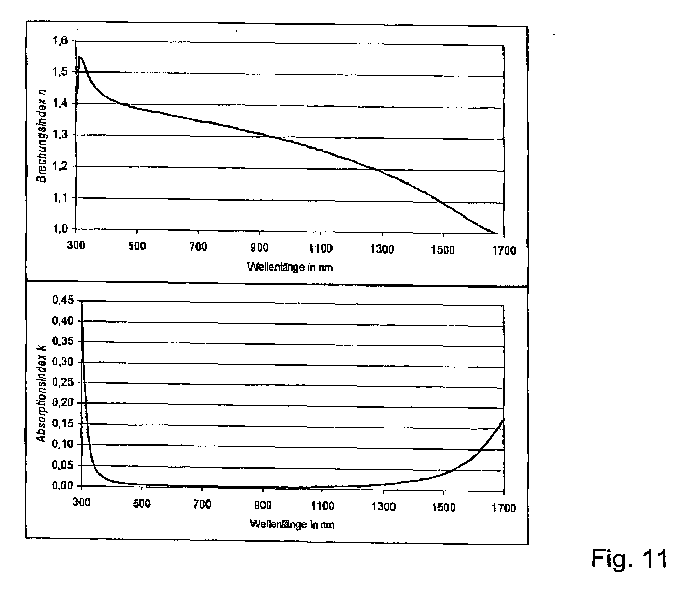

Die so erzeugten Grundelektroden aus ITO mit einer Schichtdicke von 0,6 bis 2µm besitzen typischerweise eine Rauhigkeit von 4 bis 6 nm RMS. Das Transmissionsvermögen beträgt über 90 % im Wellenlängenbereich von sichtbarem Licht (vgl. Fig. 4) bei einer Porosität von etwa 30 bis 50 %. Der Brechungsindex n=1,38 wurde mittels Ellipsometermessung bestimmt (vgl. Fig.11).

Eine ITO-Grundelektrode wurde aus einer Dispersion mittels Inkjet-Verfahren auf einem gereinigten Glassubstrat aufgedruckt, gesintert und anschließen formiert.

Ohne weitere Behandlungsschritte wurden auf die Grundelektrode rot leuchtende organische lichtemittierende Bauelemente in Form von Dioden mit dotierten Ladungsträgertransportschichten in einem Vakuumverdampfungsprozess abgeschieden. In diesem Fall wurde direkt auf die ITO-Grundelektrode eine 280 nm dicke Löchertransportschicht aus Spixe-TTB mit einer Dotierung von 1,5 w% des molekularen p-Dotanden F4-TCNQ (Tetrafluorotetracyanoquinodimethan) abgeschieden. Darauf folgt der oben allgemein beschriebene Aufbau mit einer lochseitigen Zwischenschicht NPD (10 nm), einer Emitterschicht (20 nm) aus NPD mit beigemischtem Emitter ((Tris(1-phenylisoquinoline)iridium (III), verfügbar beispielsweise von der Firma American Dye Source) (20 w%) und einer elektronseitigen. Zwischenschicht BPhen (10 nm). Die 50 nm dicke Elektronentransportschicht besteht aus BPhen, in die Cäsiumatome mit einem Verhältnis von 3:1 eindotiert sind. Als reflektierende Deckelektrode dient eine Schicht aus 150 nm aufgedampftern Aluminium.

Die Bauelemente wurden mit Deckgläschen und einem UV-härtenden Kleber verkapselt, um sie elektrooptisch zu charakterisieren. Die leuchtende Fläche beträgt 6,7 mm².

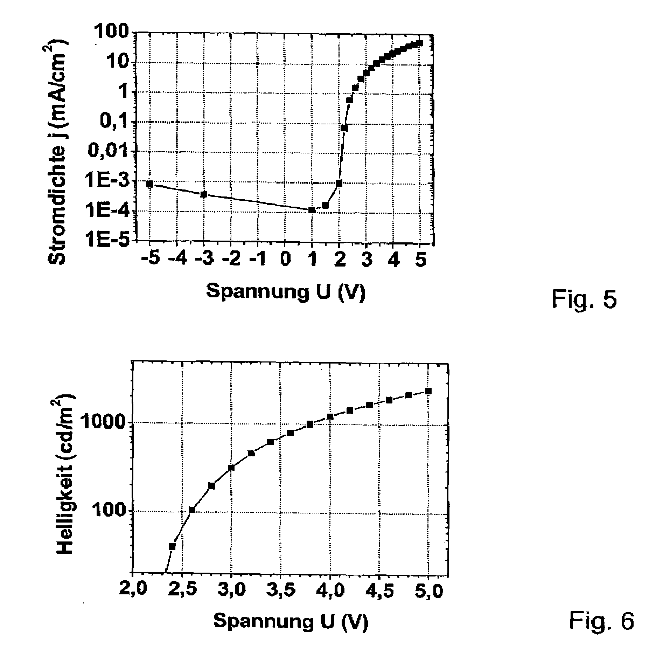

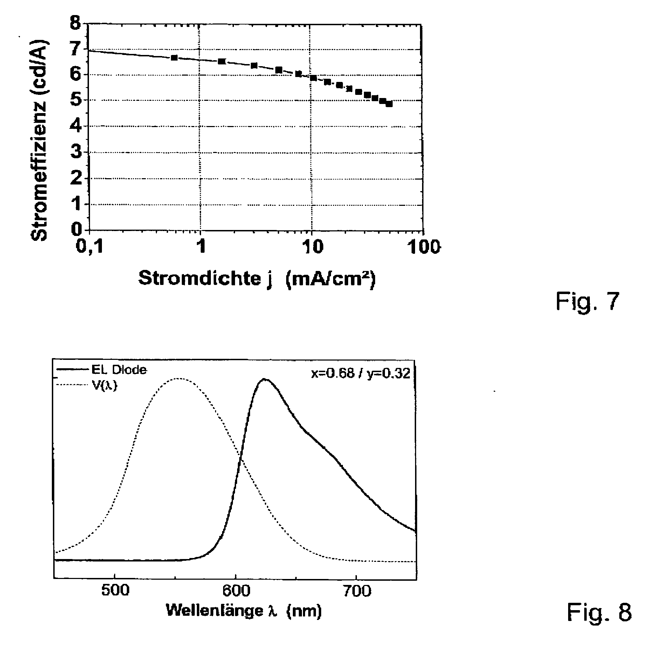

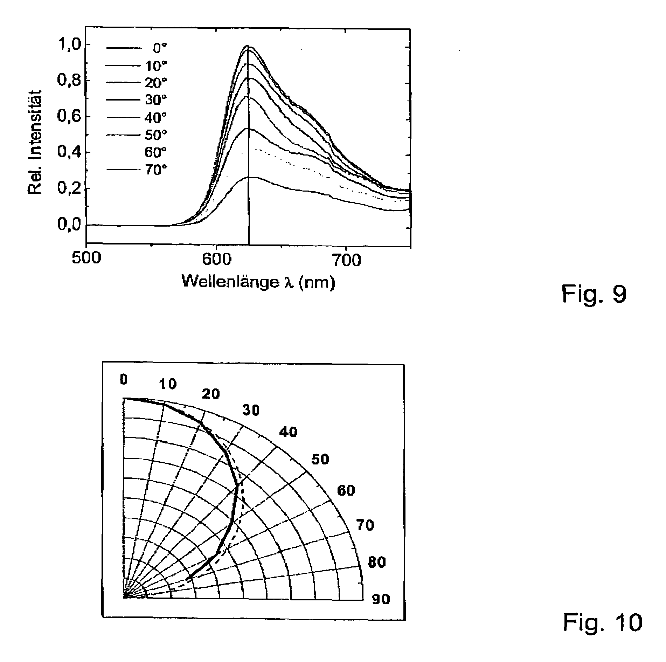

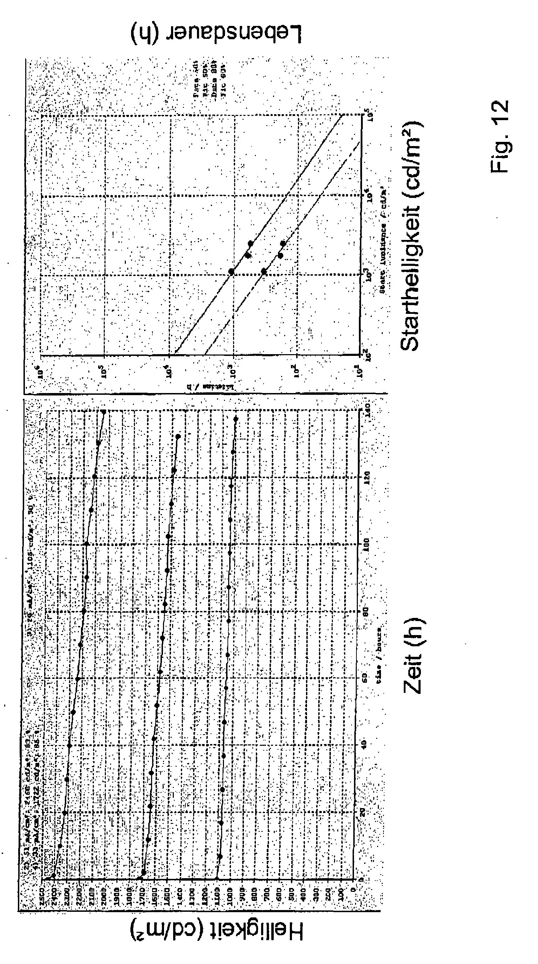

Die Strom-Spannungskennlinie eines so erzeugten Bauelementes zeigt ein deutliches Diodenverhalten mit einem Sperrverhältnis von 70000 bei 5 V und einem geringen Sperrstrom von < 10⁻³ mA/cm² bei -3 V (Fig. 5), was als Nachweis dient, dass keine Kurzschlüsse zwischen den Elektroden bestehen. Rotes Licht mit Farbkoordinaten von 0.68/0.32 (Fig. 8) wird mit einer Stromeffizienz von 5,5 cd/A abgestrahlt (Fig. 7). Eine Helligkeit von 1000 cd/m² wird bereits bei einer Spannung von 3,75 V erreicht (Fig. 6). Die Farbkoordinaten verändern sich nicht unter anderen Betrachtungswinkeln (Fig. 9). Die Intensitätsänderung entspricht der eines typischen Lambert'schen Emitters mit Cosinus-Abhängigkeit (Fig. 10). Die Lebensdauer dieses organischen lichtemittierenden Bauelements beträgt 2000 h bei 500 cd/m² (Fig. 12).

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Organisches lichtemittierendes Bauteil, insbesondere organische Leuchtdiode, bei dem eine Anordnung mit einer Grundelektrode und einer Deckelektrode sowie einem organischen Schichtbereich gebildet ist, welcher zwischen der Grundelektrode und der Deckelektrode und in elektrischem Kontakt mit der Grundelektrode und der Deckelektrode angeordnet ist und welcher mindestens eine Löchertransportsehicht, mindestens eine Elektronerttransportschicht und einen lichtemittierenden Bereich umfasst, wobei:
- die Grundelektrode mittels nasschemischen Aufbringen aus einer Dispersion als eine strukturierte, bindemittelfreie und optisch transparente Grundelektrodenschicht aus einem Grundelektrodenmaterial gebildet ist, nämlich einem optisch transparenten, elektrisch leitfähigen Oxid,
- die Grundelektrodenschicht einen Flächenwiderstand von weniger als etwa 500 Ω/Quadrat aufweist,
- die Grundelektrodenschicht einen optischen Brechungsindex von weniger als 1,8 aufweist, und
- in einer Strom-Spannungscharakteristik der Anordnung bei einer an die Anordnung angelegten Spannung von etwa -3V ein Sperrstrom kleiner als etwa 10⁻² mA/cm² ist.

2. Bauteil nach Anspruch 1, **dadurch gekennzeichnet, dass** das Grundelektrodenmaterial von Nanopartikeln elektrisch leitfähiger Materialien gebildet ist.

3. Bauteil nach Anspruch 1 oder 2, **dadurch gekennzeichnet, dass** das Grundelektrodenmaterial ein Material aus wenigstens einer Materialklasse ausgewählt aus der folgenden Gruppe von Materialklassen ist: ternäres Materialsystem wie In₂O₃:Sn (ITO), SnO₂:Sb (ATO), SnO₂:F, ZnO:Al, ZnO:In, Zn-Sn-O, Mg-In-O, Ga-In-O, Zn-In-O; quaternäres Materialsystemen wie Zn-In-Sn-O (ZITO), Zn-In-Li-O, chemisch modifizierte Variante des ternären Materialsystems, chemisch modifizierte Variante des quarternären Materialsystems, physikalisch modifizierte Varianten des ternären Materialsystems, physikalisch modifizierte Varianten des quarternären Materialsystems und Gemische hieraus.

4. Bauteil nach einem der vorangehenden Ansprüche, **dadurch gekennzeichnet, dass** die Grundelektrodenschicht eine Schichtdicke zwischen etwa 0,05 µm und etwa 20 µm, bevorzugt zwischen etwa 0,1 µm und etwa 2 µm aufweist.

5. Bauteil nach einem der vorangehenden Ansprüche, **dadurch gekennzeichnet, dass** die Grundelektrodenschicht eine RMS-Rauhigkeit im Bereich von wenigstens etwa 2 nm bis höchstens etwa 20 nm und bevorzugt im Bereich von höchstens etwa 10 nm aufweist.

6. Bauteil nach einem der vorangehenden Ansprüche, **dadurch gekennzeichnet, dass** der Flächenwiderstand der Grundelektrodenschicht kleiner als etwa 100 Ω/ Quadrat ist.

7. Bauteil nach einem der vorangehenden Ansprüche, **dadurch gekennzeichnet, dass** der optische Brechungsindex der Grundelektrodenschicht kleiner als etwa 1.5 ist.

8. Bauteil nach einem der vorangehenden Ansprüche, **dadurch gekennzeichnet, dass** die Grundelektrodenschicht lichtstreuend und mit einer Materialporosität zwischen etwa 1 % und etwa 99 %, bevorzugt zwischen etwa 20 % und etwa 60 % gebildet ist.

9. Bauteil nach einem der vorangehenden Ansprüche, **dadurch gekennzeichnet, dass** die Grundelektrodenschicht im Wellenlängenbereich von sichtbarem Licht ein Transmissionsvermögen von wenigstens 60 % und bevorzugt von wenigstens 80 % aufweist.

10. Bauteil nach einem der vorangehenden Ansprüche, **dadurch gekennzeichnet, dass** der organische Schichtbereich zwischen der Grundelektrode und dem lichtemittierenden Bereich wenigstens eine Ladungsträger transportierende Schicht mit einer Schichtdicke von wenigstens etwa 100 nm umfasst, mit der eine Oberflächenrauhigkeit der Grundelektrodenschicht zumindest teilweise ausgeglichen ist.

11. Bauteil nach Anspruch 10, **dadurch gekennzeichnet, dass** die wenigstens eine Ladungsträger transportierende Schicht elektrisch dotiert ist.

12. Bauteil nach einem der vorangehenden Ansprüche, **dadurch gekennzeichnet, dass** die Anordnung gemäß mindestens einer Bauart ausgewählt aus der folgenden Gruppe von Bauarten gebildet ist: transparenter Aufbau; Licht durch die Deckelektrode emittierender Aufbau; Licht durch die Grundelektrode emittierender Aufbau; Aufbau mit einer Schichtanordnung mit einer nicht invertierten Struktur, bei dem die Grundelektrode eine Anode ist; und Aufbau mit einer Schichtanordnung mit einer invertierten Struktur, bei dem die Grundelektrode eine Kathode ist.

13. Bauteil nach einem der vorangehenden Ansprüche, **dadurch gekennzeichnet, dass** der organischen Schichtbereich eine oder mehrere Schichten, die wahlweise mehrfach gebildet sind, ausgewählt aus der folgenden Gruppe von Schichten aufweist: elektrisch undotierte Ladungsträgertransportschicht, elektrisch dotierte Ladungsträgertransportschicht wie p-dotierte und n-dotierte Ladungsträgertransportschicht, Blockschicht, elektrisch undotierte Ladungsträgerinjektionsschicht und elektrisch dotierte Ladungsträgerinjektionsschicht.

14. Bauteil nach einem der vorangehenden Ansprüche, **dadurch gekennzeichnet, dass** die Anordnung auf einem Trägermaterial ausgewählt aus der folgenden Gruppe von Trägermaterialien gebildet ist: Glas, biegsames Trägermaterial, metallisches Trägermaterial, Kunststoff.

15. Verfahren zum Herstellen eines organischen lichtemitttierenden Bauteils, insbesondere organische lichtemittierende Diode, bei dem eine Anordnung mit einer Grundelektrode und einer Deckelektrode sowie einem organischen Schichtbereich gebildet wird, welcher zwischen der Grundelektrode und der Deckelektrode und in elektrischem Kontakt mit der Grundelektrode und der Deckelektrode angeordnet wird und welcher mit mindestens einer Löchertransporischicht, mindestens einer Elektronentransportschicht und einem lichtemittierenden Bereich gebildet wird, wobei bei dem Verfahren die Grundelektrode nasschemisch aus einer Dispersion eines Grundelektrodenmaterials als eine strukturierte und bindemittelfreie Grundelektrodenschicht aus einem Grundelektrodenmaterial, nämlich einem optisch transparenten, elektrisch leitfähigen Oxid, gebildet wird und wobei die Grundelektxodenschicht und die Anordnung den folgenden Merkmalen entsprechend konfiguriert werden: (i) ein Flächenwiderstand der Grundelektrodenschicht ist kleiner als etwa 500 Ω/Quadrat, (ii) ein optischer Brechungsindex der Grundelektrodenschicht ist kleiner als 1,8, und (iii) in einer Strom-Spannungscharakteristik der Anordnung ist bei einer an die Anordnung angelegten Spannung von etwa -3 V ein Sperrstrom kleiner als etwa 10⁻² mA/cm².

16. Verfahren nach Anspruch 15, **dadurch gekennzeichnet, dass** die Grundelektrodenschicht mittels eines strukturierenden Verfahrens ausgewählt aus der folgenden Gruppe von strukturierenden Verfahren strukturiert aufgedruckt wird: Inkjet-Druck, Offsetdruck, Gravur- / Tiefdruck, Thermotransferdruck, Laserdruck, Flexodruck, Siebdruck und Tampondruck.

17. Verfahren nach Anspruch 15 oder 16, **dadurch gekennzeichnet, dass** die Grundelektrodenschicht nach dem nasschemischen Aufbringen aus der Dispersion des Grundelektrodenmaterials nachbehandelt wird.

18. Verfahren nach Anspruch 17, **dadurch gekennzeichnet, dass** die Grundelektrodenschicht beim Nachbehandeln bei einer Temperatur im Bereich zwischen etwa 200 °C und etwa 1500 °C, bevorzugt zwischen etwa 200 °C und etwa 800 °C und weiter bevorzugt zwischen etwa 300 °C und etwa 650 °C unter Gasatmosphäre gesintert wird.

19. Verfahren nach Anspruch 18, **dadurch gekennzeichnet, dass** die Gasatmosphäre beim Sintern mindestens ein Gas ausgewählt aus der folgenden Gruppe von Gasen umfasst: Umgebungsluft, wenigstens ein Schutzgas wie Argon, CO₂, Stickstoff, Edelgas und anderes nicht-reaktives Gas wie perhalogenierte Kohlenwasserstoffe.

20. Verfahren nach einem der Ansprüche 17 bis 19, **dadurch gekennzeichnet, dass** die Grundelektrodenschicht beim Nachbehandeln bei einer Temperatur im Bereich zwischen etwa 20 °C und etwa 500 °C und bevorzugt zwischen etwa 150 °C und etwa 400 °C unter einer weiteren, der Gasatmosphäre wahlweise gleich ausgebildeten Gasatmosphäre im Verhältnis 99,9:0,1 bis 0,1:99,9, formiert wird.

21. Verfahren nach Anspruch 20, **dadurch gekennzeichnet, dass** die weitere Gasatmosphäre beim Formieren mindestens ein Gas ausgewählt aus der folgenden Gruppe von Gasen umfasst: Wasserstoff und wenigstens ein Schutzgas wie Argon, CO₂, Stickstoff, Edelgas.

22. Verfahren nach einem der Ansprüche 15 bis 21, **dadurch gekennzeichnet, dass** der organische Schichtbereich ausschließlich aus aufgedampften niedermolekularen Schichten bestehend gebildet wird.

23. Verfahren nach einem der Ansprüche 15 bis 22, **dadurch gekennzeichnet, dass** die Deckelektrode mittels Sputtern oder durch thermisches Verdampfen eines Deckelektrodenmaterials gebildet wird.

24. Verfahren nach einem der Ansprüche 15 bis 22, **dadurch gekennzeichnet, dass** das organische lichtemittierende Bauteil in einem Rolle-zu-Rolle Prozess hergestellt wird.

25. Artikel in einer Bauart ausgewählt aus der folgenden Gruppe von Bauarten: Beleuchtungsvorrichtung, Anzeigevorrichtung wie Display oder berührungssensitive Fläche, und Kennzeichnungsvorrichtung wie Etikett oder Icon, **gekennzeichnet durch** mindestens ein organisches elektronisches Bauteil nach einem der Ansprüche 1 bis 14.
